# EUROPÄISCHE PATENTSCHRIFT

(11) **EP 3 095 192 B1**
(45) Veröffentlichungstag und Bekanntmachung des Hinweises auf die Patenterteilung: **07.08.2019**
(21) Anmeldenummer: 14802059.7
(22) Anmeldetag: 21.11.2014
(51) Int. Cl.: H03K 17/16, H03K 19/003

(54) **VERFAHREN ZUR REGELUNG VON SCHALTFLANKEN FÜR GESCHALTETE ENDSTUFEN, REGELUNGSVORRICHTUNG UND ENDSTUFE**
METHOD FOR CONTROLLING SWITCHING EDGES FOR SWITCHED OUTPUT STAGES, CONTROL DEVICE, AND OUTPUT STAGE
PROCÉDÉ DE RÉGULATION DE FRONTS DE COMMUTATION D'ÉTAGES DE SORTIE À COMMUTATION, DISPOSITIF DE RÉGULATION ET ÉTAGE DE SORTIE

(30) Priorität: 17.01.2014 DE 102014200752
(43) Veröffentlichungstag der Anmeldung: 23.11.2016
(73) Patentinhaber: Robert Bosch GmbH, 70442 Stuttgart (DE)
(72) Erfinder: RITZMANN, Steffen, 72770 Reutlingen (DE); ROSAHL, Thoralf, 72800 Eningen (DE)
(86) Internationale Anmeldenummer: PCT/EP2014/075284
(87) Internationale Veröffentlichungsnummer: WO 2015/106865

(56) Entgegenhaltungen:
- US-A1- 2004 140 833
- US-A1- 2007 001 725
- US-A1- 2010 008 113
- US-B1- 6 784 708

## Beschreibung

Die vorliegende Erfindung betrifft ein Verfahren zur Regelung von Schaltflanken für geschaltete Endstufen, eine Regelungsvorrichtung zur Nachführung von Schaltflanken für geschaltete Endstufen sowie eine Endstufe mit einer Regelungsvorrichtung.

### Stand der Technik

Endstufen oder Leistungsschalter werden oftmals getaktet betrieben, um die daran angeschlossenen Lasten ein- bzw. auszuschalten oder Energie an diese zu übertragen. Bei der Taktung entstehen Schaltflanken, das heißt Übergänge von einem ausgeschalteten Zustand des Schalters in einen eingeschalteten Zustand. Bei der Auslegung der Schaltflanken gilt es, einen Kompromiss zu finden zwischen der während des Schaltens beziehungsweise während der Flanken entstehenden Verlustleistung im Schalter und der Störabstrahlung durch die wiederholten Schaltvorgänge. So bedeuten Flanken mit größerer Steigung du/dt (zeitliche Ableitung der Spannung) und damit kürzerer Zeitdauer weniger Verluste, während Flanken mit niedrigerer Steigung du/dt und damit längerer Zeitdauer weniger hochfrequente (HF)-Emissionen bedeuten.

Für viele Anwendungen ist es deshalb vorteilhaft, die Varianz der Schaltflanken bedingt zum Beispiel durch technologische Toleranzen, Temperatur oder Versorgungsspannung gering zu halten.

US 2004/01040833 A1 offenbart eine Endstufe, wobei das Ausgangssignal mit einer ersten und zweiten Referenzspannung verglichen wird. US 2007/0001725 A1 offenbart eine Vorrichtung zur Flankenratenkompensation einer steigenden Flanke.

### Offenbarung der Erfindung

Die Erfindung ist durch das Verfahren des unabhängigen Anspruchs 1 und die Vorrichtung des unabhängigen Anspruchs 5 definiert.

Das erfindungsgemäße Verfahren zur Regelung von Schaltflanken für geschaltete Endstufen umfasst folgende Schritte:
- Erfassen einer Spannung an einem Schaltknoten der Endstufe;
- Starten einer Referenzzeit, wenn die Spannung einen ersten vordefinierten Referenzwert erreicht;
- Reduzieren der Steilheit der Schaltflanke, wenn die Spannung einen zweiten vordefinierten Referenzwert an einem Ende der Referenzzeit erreicht hat; und
- Erhöhen der Steilheit der Schaltflanke, wenn die Spannung den zweiten vordefinierten Referenzwert an dem Ende der Referenzzeit nicht erreicht hat,
wobei steigende Schaltflanken und fallende Schaltflanken unabhängig voneinander geregelt werden.

Das erfindungsgemäße Verfahren ermöglicht sehr vorteilhaft, dass die Varianz oder Abweichung der Schaltflanken auf robuste Art sehr gering gehalten wird. Dies erlaubt konstantere Bedingungen bezüglich der Verlustleistung einerseits und der Hochfrequenzemission andererseits. Zudem vermeidet das Verfahren eine Veränderung der Schaltflanken bei Temperaturänderungen oder über die Lebensdauer, da die Schaltflanken nun über die Referenzzeit definiert werden. Vorteilhaft ist vorgesehen, dass ein bistabiles Kippglied an dem Ende der Referenzzeit einen Vergleichswert der Spannung zu dem zweiten vordefinierten Referenzwert übernimmt und als Zählsignal einem Zähler übergibt und wobei ein nachfolgender Digital-Analog-Umsetzer in Abhängigkeit von dem Zählerausgang einen Ansteuerungsstrom für die Endstufe reduziert oder erhöht. Diese digitale Regelung der Flanken ist einfach zu realisieren und erlaubt einen breiten Einsatzbereich.

Die Referenzzeit kann programmierbar sein, zum Beispiel über eine digitale Schnittstelle, was eine breite Anpassung des Verfahrens erlaubt.

Auch ist es möglich, dass die Referenzzeit in Abhängigkeit von Parametern der Endstufe oder des Schaltreglers variabel ist. Wenn zum Beispiel der Schaltregler eine variable Frequenz zwischen 300 kHz und 2 MHz hat, ändern sich entsprechend die Flanken, woraufhin die Referenzzeit in Abhängigkeit dieser Eingangsgröße, nämlich der Frequenz, nachgeführt wird. So ist sichergestellt, dass die Flanken für jeden Betriebszustand optimal geregelt sind.

Erfindungsgemäß wird eine Regelungsvorrichtung zur Nachführung von Schaltflanken für geschaltete Endstufen zur Verfügung gestellt, mit einem ersten Komparator zum Vergleichen einer Spannung an einem Schaltknoten der Endstufe mit einem ersten vordefinierten Referenzwert, einem von dem ersten Komparator angesteuerten Zeitgeber zum Ausgeben einer Referenzzeit, wenn die Spannung den ersten vordefinierten Referenzwert erreicht hat, einem zweiten Komparator zum Vergleichen der Spannung mit einem zweiten vordefinierten Referenzwert, einem bistabilen Kippglied, dessen Dateneingang mit dem zweiten Komparator verbunden ist und dessen Takteingang mit dem Zeitgeber derart verbunden ist, dass an einem Ausgang des Kippglieds ein Zählsignal zur Reduktion oder Erhöhung eines Ansteuerungsstroms für die Endstufe vorgesehen ist. Es werden zwei zuvor beschriebene unabhängige Regelungsvorrichtungen vorgeschlagen, eine für steigende und eine für fallende Flanken. Es gelten die gleichen Vorteile und Modifikationen wie oben beschrieben.

Die Erfindung umfasst eine einfache und robuste Vorrichtung oder Schaltung zur (digitalen) Regelung der Flanken von Endstufen und insbesondere geschalteten Endstufentransistoren. Sie basiert auf dem Vergleich einer Zeit, die die Schaltflanke zum Überwinden einer definierten Spannungsdifferenz benötigt, mit einer Referenzzeit und einer darauf basierten Veränderung der Treiberfähigkeit zur Ansteuerung der Endstufe. Dies erlaubt eine sehr schnelle Regelung für hohe du/dt, also Schaltflanken von kurzer Dauer beziehungsweise mit großer Steilheit. Zudem können große Spannungsbereiche gesteuert werden.

In einer besonderen Ausführungsform ist vorgesehen, dass das Zählsignal einem Zähler zugeführt ist und dass ein mit dem Zähler verbundener Digital-Analog-Umsetzer eingerichtet ist, in Abhängigkeit von einem Zählerausgang des Zählers den Ansteuerungsstrom für die Endstufe zu reduzieren oder zu erhöhen. Dies ist eine einfache und robuste Realisierung.

Auch ist es möglich, dass der Zeitgeber eine Stromquelle und einen Kondensator aufweist und wobei die Stromquelle und/oder der Kondensator trimmbar sind. Auf diese Weise können zum Beispiel Prozesstoleranzen, welche Zeiten von zum Beispiel 15 bis 30 Nano-Sekunden (ns) entsprechen können, ausgeglichen werden, so dass der Zeitgeber auf Referenzgröße getrimmt werden kann.

Erfindungsgemäß wird ferner eine Endstufe mit einer zuvor beschriebenen Regelungsvorrichtung zur Verfügung gestellt, mit einem Schalter, der durch den Ansteuerungsstrom betätigbar ist. Der Schalter kann vorzugsweise ein Endstufentransistor sein. Es gelten die gleichen Vorteile und Modifikationen wie zuvor beschrieben.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Schaltungsdiagramm der erfindungsgemäßen Schaltung zur Nachführung der Flanken; und
Figur 2 ein Timingdiagramm mit Signalverläufen der Schaltung aus Figur 1 und
Figur 3 ein Schaltungsdiagramm der erfindungsgemäßen Schaltung zur unabhängigen Nachführung steigender und fallender Flanken.

### Ausführungsformen der Erfindung

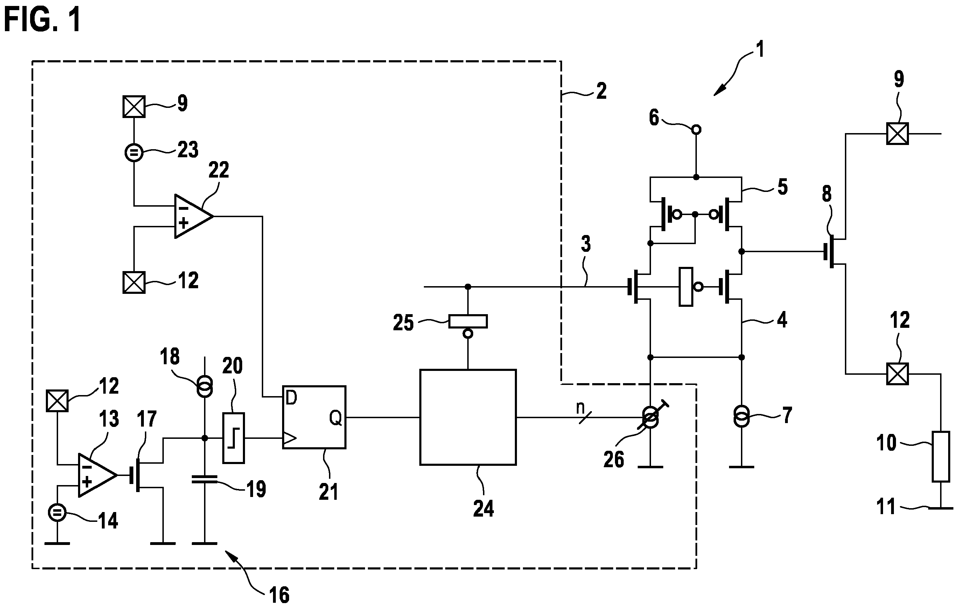

Figur 1 zeigt eine geschaltete Endstufe 1 mit einer Regelungsvorrichtung 2 zur Nachführung der Schaltflanken der geschalteten Endstufe 1. Die geschaltete Endstufe 1 umfasst einen Schalteingang 3, an dem ein Ein/Aus-Signal anliegt. Dieses Signal wird einem unteren Spiegel 4 zugeführt, welcher über einen oberen Spiegel 5 mit einem Anschluss 6 für eine Referenzspannung verbunden ist. Die zweite Seite des unteren Spiegels 4 ist mit einer Stromquelle 7 verbunden, welche den Grundstrom für die Schaltfunktion liefert. Der Ausgang der Spiegel beziehungsweise dieser Treiberschaltung ist mit einem Schalttransistor oder Endstufentransistor 8 verbunden. Der Transistor 8 ist zwischen einem Netzknoten 9 für die Eingangsspannung Vᵢₙ und zwischen einer Last 10 angeordnet. Es handelt sich also um einen sogenannten High-Side-Schalter. Durch entsprechende Anordnungen des Transistors 8 zwischen der Last 10 und einem Masseknoten 11 kann die Endstufe 1 beziehungsweise die Regelungsvorrichtung 2 auch als Low-Side-Schalter ausgeführt sein. Zwischen dem Transistor 8 und der Last 10 befindet sich ein Schaltknoten 12.

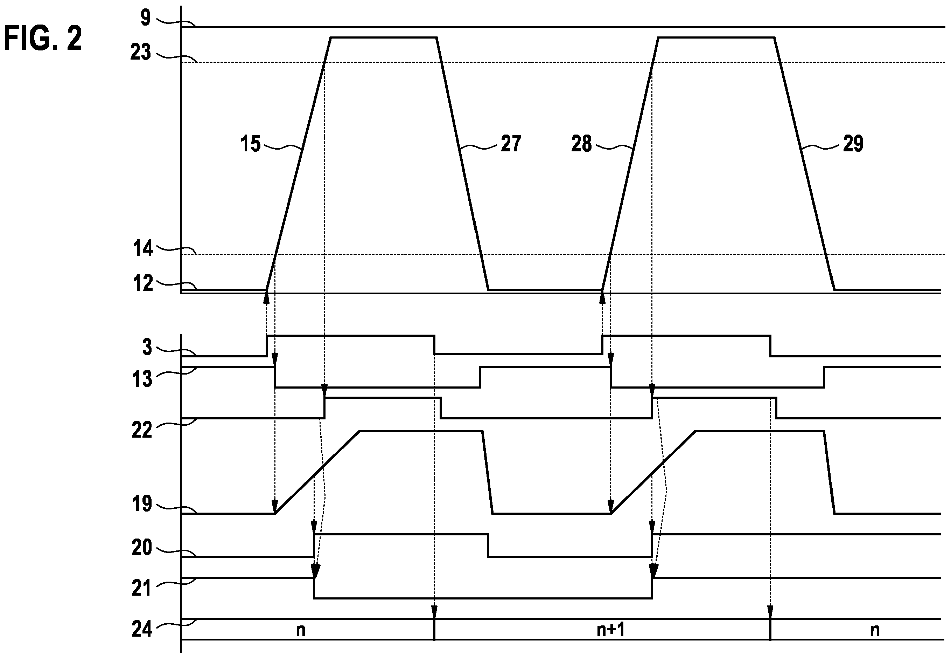

Im Folgenden wird nun die Regelungsvorrichtung 2 oder Regelungsschaltung beschrieben. Die Regelungsvorrichtung 2 kann als selbständige Einheit oder als Bestandteil der Endstufe oder des Schaltreglers 1 definiert sein. Die beiden Eingänge eines Komparators 13 sind mit dem Schaltknoten 12 und mit einer Spannungsquelle 14, welche eine untere Referenzspannung V_{low} zur Verfügung stellt, verbunden. Wenn, wie in dem in Figur 2 dargestellten Timing-Diagramm gezeigt, eine steigende Flanke 15 am Schaltknoten 12 die untere Referenzspannung 14 überschreitet, schaltet das Ausgangssignal des Komparators 13 von logisch 1 auf logisch 0.

Mit dem Absinken des Ausgangssignals des Komparators 13 startet ein hier analog ausgeführter Zeitgeber 16 die Referenzzeit. Der Zeitgeber 16 besteht aus einem Schalttransistor 17, einer Stromquelle 18 sowie einem Kondensator 19. Über die Stromquelle 18 und/oder den Kondensator 19 wird die Dauer der Referenzzeit eingestellt. In Figur 2 ist die Spannung über dem Kondensator 19 dargestellt. Diese Spannung liegt an einem Eingang eines Schmitt-Triggers 20 an, dessen Ausgang bei einer bestimmten Schwellspannung von 0 auf 1 schaltet. Der Schmitt-Trigger 20 kann ebenfalls Bestandteil des Zeitgebers 16 sein. Die Länge oder Dauer der Referenzzeit kann ebenfalls über den Schmitt-Trigger 20, genauer gesagt dessen Schwellspannung, eingestellt werden. Der Zeitgeber 16 kann alternativ auf digital realisiert sein. Der Ausgang des Schmitt-Triggers 20 ist mit einem Takteingang eines Flip-Flops oder einer bistabilen Kippstufe 21 verbunden.

Ein zweiter Komparator 22 ist mit dem Schaltknoten 12 und über eine Spannungsquelle 23, welche eine obere Referenzspannung V_{high} zur Verfügung stellt, mit dem Eingangsknoten 9 verbunden. Das Ausgangssignal des Komparators 22 wird, wie in Figur 2 dargestellt, von logisch 0 auf logisch 1 geschaltet, wenn die steigende Flanke 15 an dem Schaltknoten 12 die obere Spannungsgrenze 23 überschreitet. Dieses Ausgangssignal des Komparators 22 liegt an einem Dateneingang des bistabilen Kippglieds 21 an.

Bei Ablauf der Referenzzeit wird am Takteingang des Flipflops 21 eine positive Taktflanke erzeugt, dargestellt als Signalverlauf 20 in Figur 2, und der Wert des Komparators 22, dargestellt als Signalverlauf 22 in Figur 2, übernommen. Hat die Schaltflanke am Schaltknoten 12 die obere Grenzspannung 23 überschritten, liefert der Komparator 22 ein High-Signal, ansonsten ein Low-Signal. In dem Fall der ansteigenden Flanke 15 in Figur 2 ist das Ausgangssignal des Komparators 22 noch niedrig oder logisch 0, da dieser Anstieg zu langsam ist. Oder anders ausgedrückt hat die Spannung am Schaltknoten 12 den oberen vordefinierten Referenzwert 23 an dem Ende der Referenzzeit noch nicht erreicht. Dies führt dazu, dass der Ausgang des Flipflops 21 von logisch 1 auf logisch 0 schaltet, wie in Figur 2 als Signalverlauf 21 dargestellt.

Das Flipflop 21 steuert einen nachfolgenden Up/Down-Zähler 24. Liefert das Flipflop 21 ein High-Signal, das heißt, die Spannung an den Schaltknoten 12 hat die Schwelle V_{high} vor Ablauf der Referenzzeit überschritten, so zählt der Zähler 24 abwärts. Da das Eingangssignal 3 über einen Inverter 25 einen Zählimpuls an den Zähler 24 liefert, findet nur ein Zählereignis je Schaltvorgang der Endstufe 1 im Zähler 24 statt. Hier, das heißt bei der steigenden Flanke 15, liefert das Flipflop 21 ein Low-Signal, sodass der Zähler 24 bei dem nächsten Schaltvorgang des Eingangssignals 3 aufwärts zählt, in Figur 2 als Signalverlauf 24 dargestellt von n zu n+1.

Dieses Signal des Zählers 24 wird einem nachfolgenden Digital-Analog-Umsetzer 26 beziehungsweise einer gesteuerten Stromquelle zur Verfügung gestellt. Entsprechend erhöht der Digital-Analog-Umsetzer 26 den Gatelade- beziehungsweise Entladestrom für den Schalttransistor 8 für die nächste Flanke um 1 Bit, sodass die nächste Flanke schneller sein wird.

Dazu ändert die gesteuerte Spannungsquelle 26 den Gesamtstrom für den Schalttransistor 8 vorzugsweise um etwa 20 bis 30 %. Der Haupt- oder Grundstrom wird von der Stromquelle 7 bereitgestellt, sodass eine Überlagerung der beiden Ströme den Gatestrom für den Schalttransistor 8 bildet.

Dementsprechend ist die nächste fallende Flanke 27 und auch die nächste steigende Flanke 28 mit einem Bitwert von n+1 steiler. Bei der steigenden Flanke 28 arbeitet die Regelungsvorrichtung 2 entsprechend wie bei der ersten steigenden Flanke 15, sodass hier auf Wiederholungen verzichtet wird. Im Unterschied zu der Flanke 15 ist jedoch die steigende Flanke 28 zu schnell oder anders ausgedrückt ihre Zeitdauer zu kurz, sodass die Spannung am Schaltknoten 12 den oberen Grenzwert V_{high} schon vor Ende der Referenzzeit überschritten hat, was dazu führt, dass die Ausgänge sowohl des Komparators 22 auch als des Flipflops 21 logisch 1 oder hochgeschaltet werden. Dies führt dazu, dass der Zähler 24 herunterzählt, wodurch die dann nächste Flanke, hier die fallende Flanke 29, wiederum mit einem Bitwert n erzeugt wird.

Daher zählt der Zähler 24 im eingeschwungenen Zustand abwechselnd ein Bit aufwärts beziehungsweise abwärts. Die Flanken variieren dann noch um das geringwertigste Bit (LSB). Der Zähler 24 ist vorzugsweise mindestens als 3-Bitzähler ausgeführt, sodass acht Stufen zur Steuerung der Flankensteilheit zur Verfügung stehen. In dem in Figur 1 dargestellten Beispiel wird die steigende Flanke 15 beziehungsweise 28 vermessen und geregelt und das Ergebnis auf die nächste fallende und steigende Flanke übernommen.

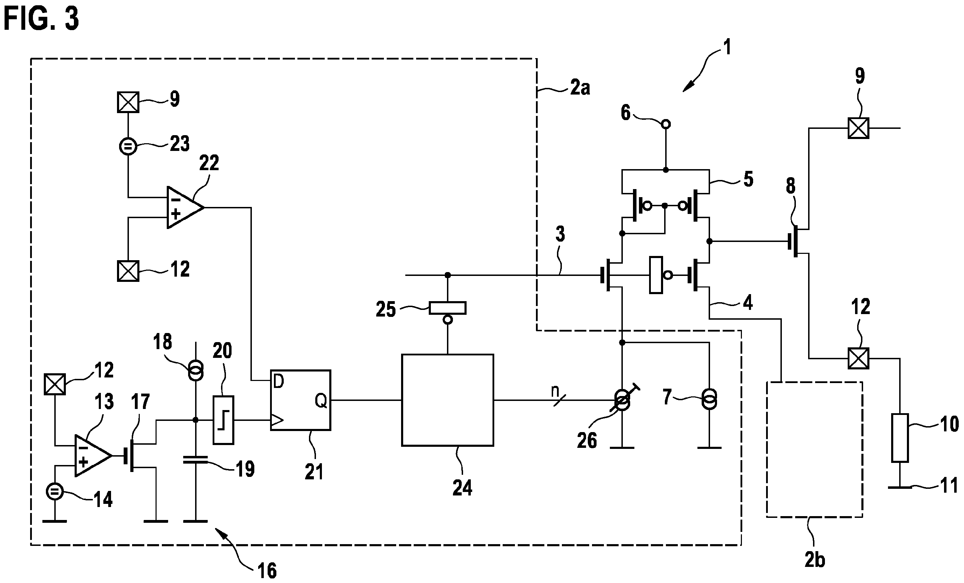

In Figur 3 ist eine Endstufe 1 mit einer Regelungsvorrichtung dargestellt, bei der es möglich ist, steigende und fallende Flanken unabhängig voneinander zu regeln. Dazu sind zwei Regelungsvorrichtungen 2a und 2b vorgesehen. Die Regelungsvorrichtungen 2a und 2b entsprechen im Wesentlichen der Regelungsvorrichtung 2 aus Figur 1. Im Unterschied zu der Regelungsvorrichtung 2 aus Figur 1 ist bei den Regelungsvorrichtungen 2a und 2b aus Figur 3 die Stromquelle 7 integriert. Während die Regelungsvorrichtung 2a analog zu der Regelungsvorrichtung 2 die steigenden Flanken regelt, regelt die Regelungsvorrichtung 2b analog zu der Regelungsvorrichtung 2 die fallenden Flanken.

## Patentansprüche

1. Verfahren zur Regelung von Schaltflanken für geschaltete Endstufen (1), wobei steigende Schaltflanken mit einer ersten Regelvorrichtung durch folgende Schritte geregelt werden:
- Erfassen einer Spannung an einem Schaltknoten (12) der Endstufe (1);
- Starten einer Referenzzeit, wenn die Spannung einen ersten vordefinierten Referenzwert erreicht;
- Reduzieren der Steilheit der Schaltflanke (15. 27), wenn die Spannung einen zweiten vordefinierten Referenzwert an einem Ende der Referenzzeit erreicht hat; und
- Erhöhen der Steilheit der Schaltflanke (15, 27), wenn die Spannung den zweiten vordefinierten Referenzwert an dem Ende der Referenzzeit nicht erreicht hat;
wobei fallende Schaltflanken mit einer zweiten Regelvorrichtung durch folgende Schritte geregelt werden:
- Erfassen einer Spannung an dem Schaltknoten der Endstufe;
- Starten einer Referenzzeit, wenn die Spannung einen ersten vordefinierten Referenzwert erreicht;
- Reduzieren der Steilheit der Schaltflanke, wenn die Spannung einen zweiten vordefinierten Referenzwert an einem Ende der Referenzzeit erreicht hat;
- Erhöhen der Steilheit der Schaltflanke, wenn die Spannung den zweiten vordefinierten Referenzwert an dem Ende der Referenzzeit nicht erreicht hat;
wobei steigende Schaltflanken (15) und fallende Schaltflanken (27) unabhängig voneinander geregelt werden.

2. Verfahren nach Anspruch 1, wobei jeweils ein bistabiles Kippglied (21) an dem Ende der Referenzzeit einen Vergleichswert der Spannung zu dem zweiten vordefinierten Referenzwert übernimmt und als Zählsignal einem Zähler übergibt und wobei ein nachfolgender Digital-Analog-Umsetzer (26) in Abhängigkeit von dem Zählerausgang einen Ansteuerungsstrom für die Endstufe (1) reduziert oder erhöht.

3. Verfahren nach Anspruch 1 oder 2, wobei die jeweilige Referenzzeit programmierbar ist.

4. Verfahren nach einem der Ansprüche 1 bis 3, wobei die jeweilige Referenzzeit in Abhängigkeit von Parametern der Endstufe (1) variabel ist.

5. Vorrichtung zur Nachführung von Schaltflanken für geschaltete Endstufen (1), umfassend
- eine erste Regelungsvorrichtung mit einem ersten Komparator (13) zum Vergleichen einer Spannung an einem Schaltknoten (12) der Endstufe (1) mit einem ersten vordefinierten Referenzwert, einem von dem ersten Komparator (13) angesteuerten Zeitgeber (16) zum Ausgeben einer Referenzzeit, wenn die Spannung den ersten vordefinierten Referenzwert erreicht hat, einem zweiten Komparator (22) zum Vergleichen der Spannung mit einem zweiten vordefinierten Referenzwert, einem bistabilen Kippglied (21), dessen Dateneingang mit dem zweiten Komparator (22) verbunden ist und dessen Takteingang mit dem Zeitgeber (16) derart verbunden ist, dass an einem Ausgang des Kippglieds (21) ein Zählsignal zur Reduktion oder Erhöhung eines Ansteuerungsstroms für die Endstufe (1) vorgesehen ist; und
- eine zweite Regelungsvorrichtung mit einem ersten Komparator zum Vergleichen einer Spannung an dem Schaltknoten der Endstufe mit einem ersten vordefinierten Referenzwert, einem von dem ersten Komparator angesteuerten Zeitgeber zum Ausgeben einer Referenzzeit, wenn die Spannung den ersten vordefinierten Referenzwert erreicht hat, einem zweiten Komparator zum Vergleichen der Spannung mit einem zweiten vordefinierten Referenzwert, einem bistabilen Kippglied, dessen Dateneingang mit dem zweiten Komparator verbunden ist und dessen Takteingang mit dem Zeitgeber derart verbunden ist, dass an einem Ausgang des Kippglieds ein Zählsignal zur Reduktion oder Erhöhung eines Ansteuerungsstroms für die Endstufe vorgesehen ist.

6. Vorrichtung (2a,2b) nach Anspruch 5, wobei jeweils das Zählsignal einem Zähler (24) zugeführt ist und wobei ein mit dem Zähler (24) verbundener Digital-Analog-Umsetzer (26) eingerichtet ist, in Abhängigkeit von einem Zählerausgang des Zählers (24) den Ansteuerungsstrom für die Endstufe (1) zu reduzieren oder zu erhöhen.

7. Vorrichtung (2a,2b) nach Anspruch 5 oder 6, wobei der Zeitgeber (16) jeweils eine Stromquelle (18) und einen Kondensator (19) aufweist und wobei die Stromquelle (18) und/oder der Kondensator (19) trimmbar sind.

8. Endstufe mit einer Vorrichtung (2a,2b) nach einem der Ansprüche 5 bis 7, **gekennzeichnet durch** einen Schalter (8), der durch den jeweiligen Ansteuerungsstrom betätigbar ist.

## Claims

1. Method for the closed-loop control of switching edges for switched output stages (1), wherein rising switching edges are controlled using a first closed-loop control apparatus by means of the following steps:
- detecting a voltage at a switching node (12) of the output stage (1);
- starting a reference time if the voltage reaches a first predefined reference value;
- reducing the gradient of the switching edge (15, 27) if the voltage has reached a second predefined reference value at an end of the reference time;
- increasing the gradient of the switching edge (15, 27) if the voltage has not reached the second predefined reference value at the end of the reference time;
wherein falling switching edges are controlled using a second closed-loop control apparatus by means of the following steps:
- detecting a voltage at the switching node of the output stage;
- starting a reference time if the voltage reaches a first predefined reference value;
- reducing the gradient of the switching edge if the voltage has reached a second predefined reference value at an end of the reference time;
- increasing the gradient of the switching edge if the voltage has not reached the second predefined reference value at the end of the reference time;
wherein rising switching edges (15) and falling switching edges (27) are controlled independently of one another.

2. Method according to Claim 1, wherein at the end of the reference time in each case one bistable multivibrator (21) assumes a comparison value for the voltage in relation to the second predefined reference value and transfers said comparison value as a count signal to a counter and wherein a downstream digital-to-analogue converter (26) takes the counter output as a basis for reducing or increasing an actuation current for the output stage (1).

3. Method according to Claim 1 or 2, wherein the respective reference time is programmable.

4. Method according to one of Claims 1 to 3, wherein the respective reference time is variable on the basis of parameters of the output stage (1).

5. Apparatus for tracking switching edges for switched output stages (1), comprising
- a first closed-loop control apparatus having a first comparator (13) for comparing a voltage at a switching node (12) of the output stage (1) with a first predefined reference value, a timer, actuated by the first comparator (13), for outputting a reference time if the voltage has reached the first predefined reference value, a second comparator (22) for comparing the voltage with a second predefined reference value, a bistable multivibrator (21), the data input of which is connected to the second comparator (22) and the clock input of which is connected to the timer (16) such that there is provision at an output of the multivibrator (21) for a count signal for reducing or increasing an actuation current for the output stage (1); and
- a second closed-loop control apparatus having a first comparator for comparing a voltage at the switching node of the output stage with a first predefined reference value, a timer, actuated by the first comparator, for outputting a reference time if the voltage has reached the first predefined reference value, a second comparator for comparing the voltage with a second predefined reference value, a bistable multivibrator, the data input of which is connected to the second comparator and the clock input of which is connected to the timer such that there is provision at an output of the multivibrator for a count signal for reducing or increasing an actuation current for the output stage.

6. Apparatus (2a, 2b) according to Claim 5, wherein in each case the count signal is supplied to a counter (24) and wherein a digital-to-analogue converter (26) connected to the counter (24) is configured to take a counter output of the counter (24) as a basis for reducing or increasing the actuation current for the output stage (1).

7. Apparatus (2a, 2b) according to Claim 5 or 6, wherein the timer (16) has in each case one current source (18) and one capacitor (19) and wherein the current source (18) and/or the capacitor (19) are/is trimmable.

8. Output stage having an apparatus (2a, 2b) according to one of Claims 5 to 7, **characterized by** a switch (8) operable by the respective actuation current.

## Revendications

1. Procédé de régulation de fronts de commutation d'étages de sortie commutés (1), dans lequel des fronts de commutation montants sont régulés au moyen d'un premier dispositif de régulation par les étapes suivantes :
- détecter une tension sur un noeud de commutation (12) de l'étage de sortie (1) ;
- déclencher un temps de référence lorsque la tension atteint une première valeur de référence prédéfinie ;
- réduire la pente du front de commutation (15, 27) lorsque la tension a atteint une deuxième valeur de référence prédéfinie à la fin du temps de référence ;
- augmenter la pente du front de commutation (15, 27) lorsque la tension n'a pas atteint la deuxième valeur de référence prédéfinie à la fin du temps de référence ;
dans lequel des fronts de commutation descendants sont régulés par un deuxième dispositif de régulation par les étapes suivantes :
- détecter une tension sur le noeud de commutation de l'étage de sortie ;
- déclencher un temps de référence lorsque la tension atteint une première valeur de référence prédéfinie ;
- réduire la pente du front de commutation lorsque la tension a atteint une deuxième valeur de référence prédéfinie à la fin du temps de référence ;
- augmenter la pente du front de commutation lorsque la tension n'a pas atteint la deuxième valeur de référence prédéfinie à la fin du temps de référence ;
dans lequel les fronts de commutation montants (15) et les fronts de commutation descendants (27) sont régulés indépendamment les uns des autres.

2. Procédé selon la revendication 1, dans lequel, à la fin du temps de référence, un élément de bascule bistable (21) prend une valeur de comparaison respective de la tension par rapport à la deuxième valeur de référence prédéfinie et la transmet à un compteur en tant que signal de comptage et dans lequel un convertisseur numérique-analogique (26) situé en aval réduit ou augmente un courant d'attaque de l'étage de sortie (1) en fonction de la sortie du compteur.

3. Procédé selon la revendication 1 ou 2, dans lequel le temps de référence respectif est programmable.

4. Procédé selon l'une des revendications 1 à 3, dans lequel le temps de référence respectif est variable en fonction de paramètres de l'étage de sortie (1).

5. Dispositif de suivi de fronts de commutation pour des étages de sortie commutés (1), comprenant
- un premier dispositif de régulation comportant un premier comparateur (13) destiné à comparer une tension sur un noeud de commutation (12) de l'étage de sortie (1) à une première valeur de référence prédéfinie, un temporisateur (16) attaqué par le premier comparateur (13) pour délivrer un temps de référence lorsque la tension a atteint la première valeur de référence prédéfinie, un deuxième comparateur (22) destiné à comparer la tension à une deuxième valeur de référence prédéfinie, un élément de bascule bistable (21) dont l'entrée de données est reliée au deuxième comparateur (22) et dont l'entrée d'horloge est reliée au temporisateur (16) de manière à ce qu'un signal de comptage destiné à réduire ou augmenter un courant d'attaque de l'étage de sortie (1) soit fourni sur une sortie de l'élément de bascule (21) ; et
- un deuxième dispositif de régulation comportant un premier comparateur destiné à comparer une tension sur le noeud de commutation de l'étage de sortie à une première valeur de référence prédéfinie, un temporisateur attaqué par le premier comparateur pour délivrer un temps de référence lorsque la tension a atteint la première valeur de référence prédéfinie, un deuxième comparateur destiné à comparer la tension à une deuxième valeur de référence prédéfinie, un élément de bascule bistable dont l'entrée de données est reliée au deuxième comparateur et dont l'entrée d'horloge est reliée au temporisateur de manière à ce qu'un signal de comptage destiné à réduire ou augmenter un courant d'attaque de l'étage de sortie soit fourni sur une sortie de l'élément de bascule.

6. Dispositif (2a, 2b) selon la revendication 5, dans lequel le signal de comptage est envoyé à un compteur (24) et dans lequel un convertisseur numérique-analogique (26) relié au compteur (24) est conçu pour réduire ou augmenter le courant d'attaque de l'étage de sortie (1) en fonction d'une sortie de comptage du compteur (24).

7. Dispositif (2a, 2b) selon la revendication 5 ou 6, dans lequel le temporisateur (16) comporte respectivement une source de courant (18) et une capacité (19) et dans lequel la source de courant (18) et/ou le condensateur (19) sont ajustables.

8. Étage de sortie comportant un dispositif (2a, 2b) selon l'une des revendications 5 à 7, **caractérisé par** un commutateur (8) qui peut être actionné par le courant d'attaque respectif.
